# EUROPEAN PATENT SPECIFICATION

(11) **EP 1 801 269 B1**
(45) Date of publication and mention of the grant of the patent: **05.10.2011**
(21) Application number: 06024629.5
(22) Date of filing: 28.11.2006
(51) Int. Cl.: C30B 29/40, C30B 23/02, C30B 25/02, H01L 21/20

(54) **Process for producing a free-standing III-N layer, and free-standing III-N substrate**
Verfahren zur Herstellung einer freistehenden III-N Schicht und dadurch hergestelltes freistehende III-N Substrat
Procédé pour la production d'une couche autoporteuse du type III-N ainsi qu'un substrat autoporteur du même type

(30) Priority: 21.12.2005 US 752049 P
(43) Date of publication of application: 27.06.2007
(73) Proprietor: Freiberger Compound Materials GmbH, 09599 Freiberg (DE)
(72) Inventor: Leibiger, Gunnar, Dr., 09599 Freiberg (DE); Habel, Frank, 09599 Freiberg (DE); Eichler, Stefan, Dr., 01187 Dresden (DE)
(74) Representative: Oser, Andreas

(56) References cited:
- US-A1- 2005 028 888
- US-B1- 6 218 280
- US-B2- 6 648 966
- KRYLIOUK O ET AL: "Growth of GaN single crystal substrates" MATERIALS SCIENCE AND ENGINEERING B, ELSEVIER SEQUOIA, LAUSANNE, CH, vol. 59, no. 1-3, 6 May 1999 (1999-05-06), pages 6-11, XP004173194 ISSN: 0921-5107
- DOOLITTLE W A ET AL: "MBE growth of high quality GaN on LiGaO2 for high frequency, high power electronic applications" SOLID STATE ELECTRONICS, ELSEVIER SCIENCE PUBLISHERS, BARKING, GB, vol. 44, no. 2, February 2000 (2000-02), pages 229-238, XP004186192 ISSN: 0038-1101
- POROWSKI S: "Near defect free GaN substrates" MRS INTERNET JOURNAL OF NITRIDE SEMICONDUCTOR RESEARCH, MATERIALS RESEARCH SOCIETY, WARRENDALE, PA,, US, vol. 4S1, 1999, pages 1-11, XP002277474 ISSN: 1092-5783
- LIU L ET AL: "Substrates for gallium nitride epitaxy" MATERIALS SCIENCE AND ENGINEERING R: REPORTS, ELSEVIER SEQUOIA S.A., LAUSANNE, CH, vol. 37, no. 3, 30 April 2002 (2002-04-30), pages 61-127, XP004349792 ISSN: 0927-796X

## Description

The present invention relates to processes for producing free-standing III-N layers. The invention also relates to free-standing III-N substrates obtainable by the processes. These free-standing III-N layers are very suitable for use as for example, substrates for the manufacture of components (devices). The term "III-N" denotes a Nitride layer, where the III denotes at least one element from group III of the periodic system, selected from Al, Ga and In. Thus, a III-N compound can contain, aside from any impurities, Gallium and Nitrogen, Aluminum and Nitrogen, Indium and Nitrogen, Gallium Aluminum and Nitrogen, Gallium Indium and Nitrogen, Aluminum Indium and Nitrogen, or Gallium Aluminum Indium and Nitrogen. III-N compounds will be referred to below collectively as (Ga,Al,In)N on occasion.

Components (devices) for (Ga,Al,In)N-based light-emitting or LASER diodes have customarily been grown on foreign substrates, such as Al₂O₃ or SiC. The drawbacks relating to crystal quality and consequently component life and efficiency which result from the use of foreign substrates can be mitigated through growth on III-N substrates, such as (Ga,Al)N substrates. Until now, however, such substrates have not been available in sufficient quantities, which has largely been due to the enormous difficulties encountered during the bulk production of such substrates.

The publication "Large Free-Standing GaN Substrates by Hydride Vapor Phase Epitaxy and LASER-Induced Liftoff" by Michael Kelly et al. (Jpn. J. Appl. Phys. Vol. 38, 1999, pp. L217-L219), suggests a method for producing a thick GaN layer by means of Hydride Vapor Phase Epitaxy (HVPE, also occasionally referred to as "Halide Vapor Phase Epitaxy") on a substrate made from sapphire (Al₂O₃). For this purpose, the document describes irradiating the GaN-coated sapphire substrate with a LASER, with the result that the GaN layer is locally thermally decomposed at the interface with the sapphire substrate, and as a result lifts off from the sapphire substrate.

The publication "Comparison of HVPE GaN films and substrates grown on sapphire and on MOCVD GaN epi-layer" (Kim et al., Materials Letters 46, 2000, pp. 286-290) describes the deposition of a first thin layer of GaN on the sapphire substrate by means of metalorganic vapor phase epitaxy (MOCVD), followed by the growth of a second, thick GaN layer on the first layer by means of HVPE. Kim et al. also describe removing the sapphire substrate by mechanical polishing to produce free-standing GaN layers.

The use of LiAlO₂ as a substrate material for the production of GaN layers has been described by a number of working groups. Dikme et al.used LiAlO₂ as a substrate material for the deposition of a GaN layer by means of MOCVD. ("Growth studies of GaN and alloys on LiAlO2 by MOVPE" by Dikme et al. in Phys. Stat. Sol. (c) 2, No. 7, pp. 2161-2165, 2005). Sun et al., in "Impact of nucleation conditions on the structural and optical properties of M-plane GaN (1-100) grown on γ-LiAlO2" (Journal of Appl. Phys., Vol. 92, No. 10, pp. 5714-5719, 2002), describe the deposition of a GaN layer on a γ-LiAlO₂ substrate by means of plasma-assisted molecular beam epitaxy. Further, Doolittle et al. (Solid State Electronics 44, pp. 229-238 (2000)) report about MBE growth of GaN on LiGaO₂ substrate. By referring to other references, the problem of diffusion of impurities such as lithium and oxygen emanating from the substrate is mentioned, and nitidization for preventing Li-diffusion and reduction of substrate temperatures used for MBE growth are also indicated. However, none of these processes lead to the production of a free-standing (Al,Ga)N substrate. Furthermore, Kryliouk et al., in US 6,218,280, describe a method for producing III-N substrates by MOVPE growth of a III-N layer on an oxide substrate followed by HVPE growth of a second III-N layer on the first III-N layer which was deposited by means of MOVPE. LiAlO₂ is theoretically mentioned as a substrate material. In Materials Science and Engineering B 59 (1999), pp. 6-11, Kryliouk et al. describe forming a nitrided surface layer on a LiGaO₂ substrate, then forming a first 0.2-0.3 µm thin GaN layer by means of MOVPE at 850°C, and subsequently forming a second 100-300 µm thick GaN layer by means of HVPE in a combined MOVPE/HVPE apparatus. Maruska et al., in the article "Freestanding nonpolar gallium nitride substrates" (OPTO ELECTRONICS REVIEW 11, No. 1, 7-17, 2003), describe the production of a free-standing GaN layer by deposition of a GaN layer on a γ-LiAlO₂ substrate by means of HVPE. It is stated that after the layer growth, the γ-LiAlO₂ substrate mostly flakes off during cooling, and the remaining substrate material can be removed using hydrochloric acid. However, this process has the drawback that the defect density of the free-standing GaN layers produced in this way is relatively high. *cf.* also Maruska et al., in US 6,648,966.

US-20050028888 discloses a technique for producing by MOCVD an epitaxial wafer having at least two group III-N layers and at least one group III-N interlayer formed at a lower temperature than the growth temperature of each of said at least two group III-N layers.

The growth of bulk material at a high pressure has been described by Porowski (MRS internet J. Nitride Semicond. Res 4S1, 1999, G1.3). This process provides high-quality GaN bulk material but has the drawback that it has hitherto only been possible to produce small GaN substrates with an area of at most 100 mm². Moreover, the production process takes up considerable time compared to other processes and is technologically complex, due to the extremely high growth pressures.

Therefore, the embodiments of the present invention seek to provide a process which allows high-quality free-standing III-N layers to be produced quickly and reliably and essentially free of unwanted impurities and in a simple way, and to provide a corresponding free-standing III-N substrate.

### SUMMARY OF THE INVENTION

It is thus an object of the invention to provide a process for producing a free-standing III-N layer and free-standing III-N substrates.

It is a further object of the invention to provide free-standing III-N substrates produced by these processes.

It is a further object of the invention to provide a process for producing a III-N layer, where III denotes at least one element from group III of the periodic system, selected from Al, Ga and In,, comprising depositing on an Li(Al,Ga)Ox substrate, where 1 ≤ x ≤ 3, a first III-N layer at a first temperature; and depositing on the first III-N layer a second III-N layer at a second temperature, wherein the first temperature is significantly lower than the second temperature, and further where the first temperature is at least 200 K lower than the second temperature, an more particularly where the first temperature is at least 350 K lower than the second temperature.

It is a further object of the invention to provide a process for producing a III-N layer, where III denotes at least one element from group III of the periodic system, selected from Al, Ga and In,, comprising depositing on an Li(Al,Ga)Ox substrate, where 1 ≤ x ≤ 3, a first III-N layer at a first temperature; and depositing on the first III-N layer a second III-N layer at a second temperature, wherein the first temperature is significantly lower than the second temperature, such that during deposition at the first temperature, contaminants in the substrate, such as Li and O, diffuse to a lesser extent into the first III-N layer.

It is a further object of the invention to provide a process for producing a III-N layer, where III denotes at least one element from group III of the periodic system, selected from Al, Ga and In,, comprising depositing on an Li(Al,Ga)Ox substrate, where 1 ≤ x ≤ 3, a first III-N layer at a first temperature using Molecular Beam Epitaxy with an Ion-Beam Source; and depositing on the first III-N layer a second III-N layer at a second temperature, such that during deposition at the first temperature, contaminants in the substrate, such as Li and O, diffuse to a lesser extent into the first III-N layer and such that lower surface mobilities at the first temperature are at least in part compensated for by the use of the Ion-Beam Source.

It is a further object of the invention to provide a process for producing a free-standing III-N layer, where III denotes at least one element from group III of the periodic system, selected from Al, Ga and In, comprising depositing on an Li(Al,Ga)Ox substrate, where 1 ≤ x ≤ 3; at least one first III-N layer by means of molecular beam epitaxy (MBE); and depositing on the at least one first III-N layer at least one second III-N layer by means of hydride vapor phase epitaxy (HVPE).

It is a further object of the invention to provide improved III-N substrates produced by the processes of the invention.

It is a further object of the invention to provide improved III-N substrates comprising a heteroepitaxial III-N layer having a thickness of less than 2 microns and a homoepitaxial III-N layer having a thickness of at least 200 microns, wherein said homoepitaxial III-N layer, optionally in addition said heteroepitaxial III-N layer, is substantially free of impurities derivable from the foreign substrate or from an uncontrolled incorporation from the epitaxy process.

It is a further object of the invention to provide improved III-N substrates with a diameter greater than five centimeters.

The objects are solved by processes according to claims 1 and 2, respectively, and by the free-standing III-N substrate according to claim 14. Preferred embodiments are set forth in the further claims.

Further objects, features and advantages of the present invention will become apparent from the detailed description of preferred embodiments that follows, when considered together with the accompanying figures.

### BRIEF DESCRIPTION OF THE DRAWINGS

In the drawings:

Figs 1a to 1e illustrate various steps of the process for producing a free-standing III-N layer in accordance with one embodiment of the invention,

Fig. 2 diagrammatically depicts an MBE apparatus which can be used in the process in accordance with one embodiment of the invention; and

Fig. 3 diagrammatically depicts an HVPE apparatus which can be used in the process in accordance with one embodiment of the invention.

### DETAILED DESCRIPTION OF THE PREFERRED EMBODIMENTS

The free-standing layers that may be produced, due to the relatively low growth temperatures used during the layer growth by means of, for example, MBE, advantageously have low defect densities and a high crystal quality. The MBE process allows for less diffusion of substrate impurities into a III-N crystal during a first stage of growth. The undesirable diffusion of Al and/or Ga, Li and O out of the production substrate into the III-N layer is very low or even absent altogether, due to the low growth temperature in an MBE growth step. Impurities made up of Al and/or Ga, Li and O, and corresponding imperfections, which result from the Li(Al,Ga)O₂ substrates used for the production, are therefore substantially absent from the free-standing product or only present in such small traces that there is scarcely any disruption or defect to the component.

Corresponding diffusion-controlling effects according to the invention, thanks to the growth of the heteroepitaxial III-N layer at the first low temperature, would be likewise feasible when using foreign substrates other than the aforementioned Li(Al,Ga)Ox substrate, for example when using sapphire or silicon carbide substrates or the like. Hence, in such cases of providing free-standing III-N substrates from other foreign substrates also, undesirable diffusion of Al and O, or of Si and C out of the foreign production substrate into the III-N layer is very low or even absent altogether. Thus, uncontrolled presence of impurities can be avoided, whereas controlled doping by suitable growth conditions of course still remains possible, as will be described further below.

Owing to the use of the combination of MBE and HVPE with the associated advantages in the production process according to the preferred embodiment of the invention, and in a corresponding avoidance of MOCVD process conventionally used in the provision of free-standing III-N substrates of the prior art, the free-standing III-N substrates provided by the present invention are further substantially free of MOCVD-associated uncontrolled impurities, in particular O, H and C impurities.

In accordance with the present invention, it is thus possible to provide preferred free-standing III-N substrates, wherein the thick homoepitaxial III-N layer, optionally in addition the thin heteroepitaxial III-N layer, is substantially free of any one of impurities which may derive from a foreign production substrate (for example by diffusion) or from uncontrolled epitaxy growth conditions (such as O and C and H which are likely present in MOCVD growth systems), in particular impurities selected from the group consisting of Li, O and C. In case of GaN layers being grown on a LiAlOₓ substrate, in case of AlN layers being grown on a LiGaOₓ substrate, or case of InN layers being grown on a Li(Al,Ga)Oₓ substrate, the epitaxially grown III-N layer can be further made essentially free of the foreign substrate impurity element other than the active element, Al and Ga respectively. In a further preferred embodiment, the free-standing III-N substrate of the invention is essentially free of all of Li, O and C at least in the thick homoepitaxial III-N layer, optionally in addition the thin heteroepitaxial III-N layer.

In the context of the present invention, "impurities" means substances or elements undesirable associated with process requirements (either deriving from foreign substrates, or from disadvantageous process systems associated with relatively uncontrolled impurity incorporation, such as MOCVD), unlike desired impurities doped in controlled amounts. Further in the context of the present invention, "essentially free" means, at a maximum, spurious amounts acceptable for a defect-free operation of the component (device) built on the free-standing substrate of the invention, typically at an amount less than 10¹⁹ cm⁻³, preferably less than 10¹⁸ cm⁻³, more preferably less than 10¹⁷ cm⁻³, and particularly less than 10¹⁶ cm⁻³ for each of the undesired impurity. Most preferably, the aforementioned impurities are below detectable limits.

Other impurities are restricted to inevitable traces which originate from the starting materials. This is distinct from GaN on LiAlO₂ obtained by means of MOVPE growth, where very high concentrations of oxygen (~ 5x10¹⁹ cm⁻³) and lithium (~ 5x10¹⁸ cm⁻³) have been recorded in the GaN (cf. the above-referenced publication by Dikme et al. 2005).

The free-standing substrate according to the present invention thus provides a unique combination of features, in that the avoidance of impurities as described above is possible at a desirably low thickness of the heteroepitaxial layer of below 2 µm (micron). Preferably, the heteroepitaxial III-N layer has still a lower thickness of 1 µm (micron) or less, and even a further lower thickness of less than 0.2 µm (micron).

In accordance with a preferred embodiment of the free-standing substrate of the present invention, the heteroepitaxial III-N layer is a MBE heteroepitaxially grown III-layer, and the homoepitaxial III-N layer is a HVPE homoepitaxially grown III-N layer.

By combining the growth processes MBE/HVPE for the III-N crystal, together with the Li(Ga,Al) oxide production substrate used, the result is not only good process economics but also major advantages with regard to the combination of defect or imperfection density, dislocation density and impurities.

Another advantage of the invention is that the removal of the III-N layer from the substrate take place completely or at least mostly during cooling following the layer growth, thereby obviating any complex re-machining.

A further advantage of the invention resides in the fact that the layer thicknesses required to use the free-standing III-N layers as substrate material can be reached quickly, due to the high growth rates of HVPE.

According to the invention, the size of the free-standing III-N layers is limited only by the size of the Li(Al,Ga)O₂ substrates, such that diameters of 5 cm and above can be realized.

The invention is applicable to crystalline, in particular single-crystal III-N compounds, where III denotes at least one element from group III of the periodic system, selected from Al, Ga and In. Examples of possible III-N compounds include quaternary compounds, such as (Ga,Al,In)N, ternary compounds, such as (Ga,Al)N, (Ga,In)N and (Al,In)N or binary compounds, such as GaN or A1N. All conceivable atomic ratios among the selected elements from group III, as indicated by way of example in parenthesis above, are conceivable, i.e. from 0 to 100 atomic % for the respective element (e.g. (Ga,Al)N = Ga_{y}Al_{1-y}N, where 0 ≤ y ≤ 1). (Ga,Al)N and GaN are particularly preferred. The following description of particular embodiments can be applied not only to the examples of III-N compounds given therein but also to all possible III-N compounds.

The material of the production substrate is preferably Li(Al,Ga)Ox, where 1 ≤ x ≤ 3 and more preferably 1.5 ≤ x ≤ 2.5. The index is preferably around 2 and more preferably precisely 2.0. (Al,Ga) denotes Al or Ga in each case alone or any desired mixture with atomic ratios between 0 and 100 atomic %. The preferred production substrate is LiAlO₂, in particular in the gamma (γ) modification. The following description of preferred embodiments can be applied not only to the LiAlO₂ substrate referred to therein, but also to other Li(Al,Ga)Ox substrates.

Turning now to the drawings, the invention is described in more detail below with reference to the figures, although without being restricted to the exemplary embodiments described therein.

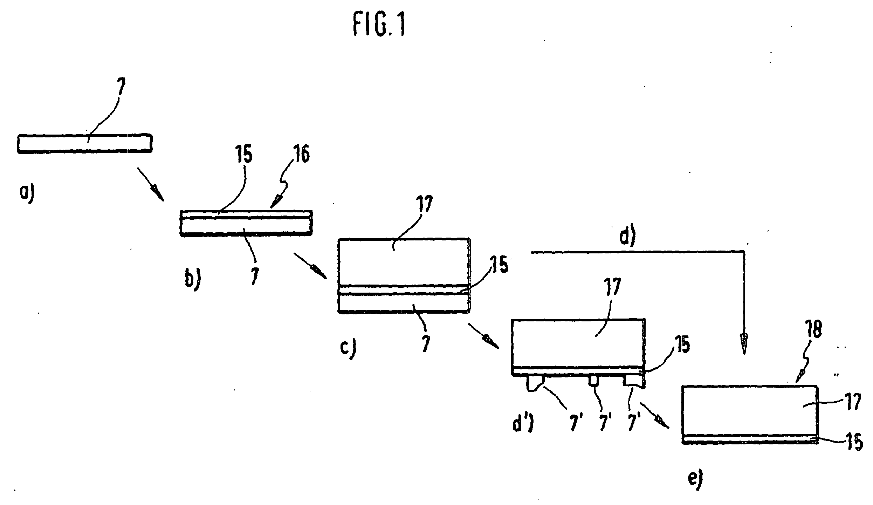

In a first growth step, a III-N layer and more preferably a (Ga,Al,In)N, (Ga,Al)N, (Ga,In)N or GaN layer 15 of a suitable thickness in the range from 10-1000 nm, e.g. approximately 100 nm, is deposited by means of, for example, ion beam assisted molecular beam epitaxy (IBA-MBE) on a γ-LiAlO₂ substrate 7 illustrated in Fig.1a, with a diameter of, for example, 2 inches (approx. 5 cm). Larger substrate diameters, such as 3 inches (approx. 7.6 cm) or 4 inches (approx. 10 cm) or more are also conceivable, depending on the usable and available substrate.

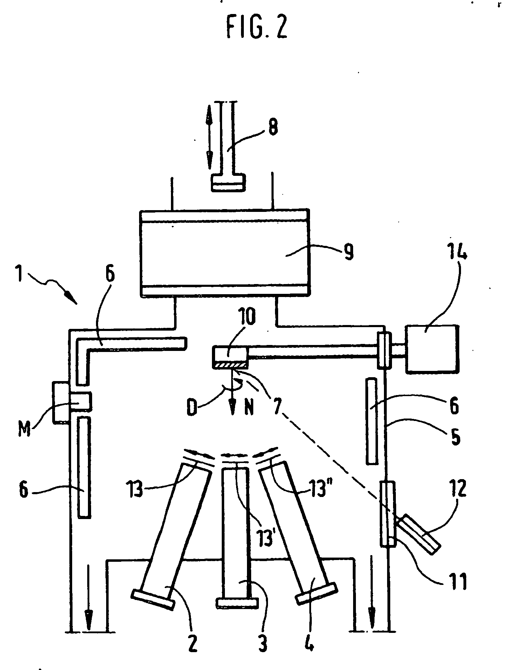

A molecular beam epitaxy apparatus 1 (MBE apparatus), which is known per se and is diagrammatically depicted in cross section in Fig. 2, is used for this purpose. The MBE apparatus is, for example, a standard system produced by Riber. The exemplary embodiment shown in Fig. 2 includes a Ga effusion cell 2 and a Nitrogen source 3, which is designed as a Nitrogen hollow anode ion source. As shown in Fig. 2, the MBE apparatus 1 may additionally have an Al effusion cell 4 if a (Ga,Al)N layer is to be formed. For a GaN layer, the additional Al effusion cell 4 can be omitted. For (Ga,Al,In)N or (Ga,In)N layers, it is possible to provide an effusion source for another element, such as, for example, In, which can be used in addition to or instead of the effusion source for Al.

The MBE apparatus has a growth chamber 5, which can be brought to a background pressure in the UHV range using a pump system indicated by two arrows P and P'. The pump system is assisted by refrigeration traps 6 cooled using Nitrogen. The pressure in the growth chamber 5 can be measured using a pressure-measuring device M.

The γ-LiAlO₂ substrate 7 is introduced into the growth chamber 5 through a lock 9 using a transfer mechanism 8, and is held in the growth chamber by a substrate holder 10. Then, the growth chamber 5 is brought to a working pressure of approximately 5 × 10⁻⁸ Pa, and the substrate is heated, using a substrate heater integrated in the substrate holder 10, to a suitable growth temperature, preferably less than 800°C, more preferably less than 700°C, and especially less than 600 °C, such as, for example, a range from approximately 500 to 800°C, preferably 600 to 700°C, in particular in a range from for example 630 to 650°C. The temperature of the substrate surface can be measured through a window 11 in the wall of the growth chamber 5, using a pyrometer 12.

Particle jets discharged by the Ga effusion cell 2, the Nitrogen cell 3 and if (where used) the Al effusion cell 4 are blocked by shutters 13, 13' and 13" and thereby prevented from contacting the substrate 7 until layer growth is to begin. After the surface temperature of the substrate 7 has stabilized at the desired growth temperature for a predetermined time, the start of layer growth is initiated by moving the shutters 13, 13' and (where necessary) 13" out of the region of the particle jet.

During layer growth, the flow of Ga particles is, for example, approximately 5 × 10¹³ to 2 × 10¹⁴ cm⁻² s⁻¹. The energy of the majority of the ions from the Nitrogen source is preferably below 25 eV. The energy of the ions is, on the one hand, high enough to ensure a high surface mobility on the surface of the growth front, but on the other hand, is sufficiently low to ensure that the crystal lattice is not damaged. A suitable growth rate is expediently in a range from 0.5 to 2 nm/min, e.g. around 1.25 nm/min.

A manipulator 14 is used to rotate the substrate holder 10 together with the substrate 7 around the axis N normal to the substrate surface during the layer growth, as indicated by the arrow D. The rotation of the substrate 7 compensates for local differences in the growth conditions and homogenizes the layer growth over the surface of the substrate 7.

After the growth of a III-N or more preferably (Ga,Al,In)N, (Ga,Al)N, (Ga,In)N or GaN layer with a thickness of, for example, approximately 10 to 1000 nm, the shutters 13, 13' and (where necessary) 13" are moved back into position in front of the sources 2, 3 (where used) 4, in order to interrupt the particle jet streaming towards the substrate, with the result that layer growth is terminated.

Immediately after the layer growth has terminated, the temperature of the substrate 7 is brought to close to room temperature, and the γ-LiAlO₂ substrate 7 with the III-N layer 15 which has grown on it is removed from the growth chamber 5 through the lock 9 using the transfer mechanism 8.

The reduction in layer-formation temperature due to, for example, the use of an N₂-ion source in MBE, can reduce the compressive stress that is produced in the first layer during cooling by differences in the thermal expansion coefficients of III-N and LiAlO₂. During the initial heating portion of the subsequent process step, the compressive stress will gradually be reduced until the temperature of the first process step is reached, at which point the thermally induced compressive stress will be zero. When the temperature is increased above this point, the compressive stress will become a tensile stress. The modified stress state in the first III-N layer (when compared to a layer formed at a higher temperature) results in a lower overall compressive stress.

Then, as shown in the step according to Fig. 1c, a second III-N layer 17 is deposited by means of HVPE on the template 16 (shown in Fig. 1b), which comprises the γ-LiAlO₂ substrate 7 and the first III-N layer 15 which has been deposited thereon by means of MBE.

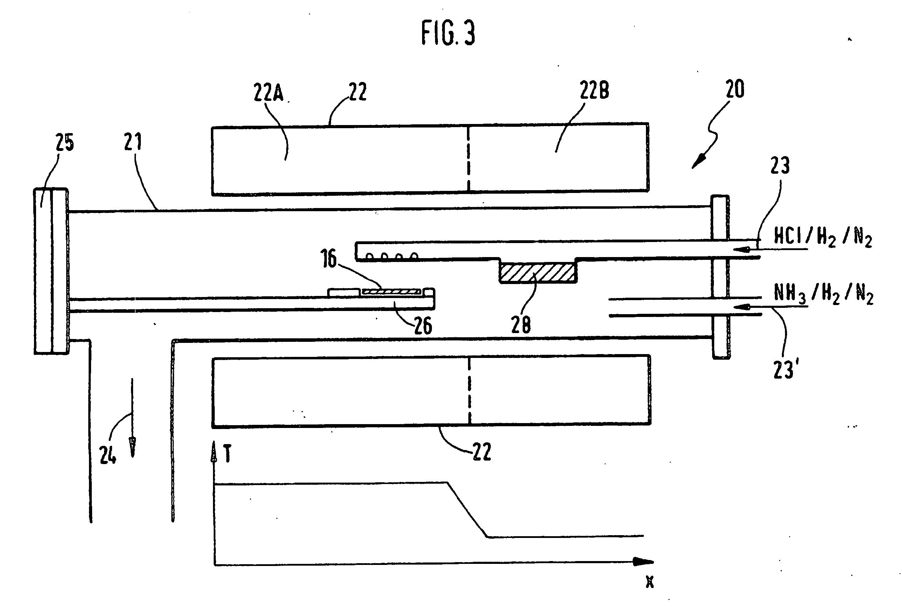

The deposition of the second III-N layer 17 is done using an HVPE apparatus which is known *per se,* such as, for example, a horizontal LP-VPE apparatus produced by Aixtron. The HVPE apparatus 20 according to one possible embodiment which is diagrammatically depicted in Fig. 3 in cross section, includes a quartz reactor 21, a multizone furnace 22 surrounding it, a gas supply 23, 23' indicated by arrows and a pump and exhaust system 24 indicated by an arrow.

First of all, the template 16, on a substrate holder 26, is introduced into the reactor 21 through the loading and unloading flange 25. For growth operations, a gas-swirling device (not shown) can be provided at the substrate holder 26 in the region of the template, in order to support the template on the substrate holder without contact. Then, the pump and exhaust system 24 is used to bring the reactor to the desired process pressure, preferably less than 1000 mbar, for example, approximately 950 mbar.

The multizone furnace has a first zone 22A, which sets the growth temperature on the surface of the substrate, and a second zone 22B, which sets the temperature in the region of a Ga well 28. H₂ or N₂ as carrier gas is admitted to the reactor via the gas supply 23, 23'. To produce gallium chloride *in situ,* the Ga which is present in the Ga well is vaporized by setting a suitable temperature in the zone 22B of the multizone furnace 22, e.g., approximately 850°C, and reacted with HCl, which is made to flow in from the gas supply 23 using H₂/N₂ carrier gas in a suitable gas mixing ratio and at a suitable flow rate. The Gallium Chloride which is produced *in situ* flows out of the openings at the end of the inflow tube 23 into the reactor 21, where it is mixed with NH₃, which is made to flow in from the inflow tube 23' together with an H₂/N₂ carrier gas mixture in a suitable gas mixing ratio and at a suitable flow rate to establish a desired NH₃ partial pressure of, for example, approximately 6 to 7 · 10³ Pa. As will be clear from the temperature profile at the bottom of Fig. 3, a temperature which is higher than that of the zone 22B is established in the zone 22A of the multizone furnace 22, in order to set a substrate temperature of expediently approximately 950 - 1100°C, e.g., around 1050°C. GaN is deposited on the substrate holder.

If, for example, a (Ga,Al,In)N, (Ga,Al)N or (Ga,In)N layer 17 is to be deposited instead of a GaN layer, additional Al and/or In wells is/are provided in the HVPE apparatus 20. The incoming flow of corresponding aluminum and/or indium chloride into the reactor then takes place as a result of the admission of HCl in suitable carrier gas of for example H₂/N₂, similarly to what was demonstrated by the inflow tube 23 for Ga in Fig. 3.

The growth of the layer deposited by means of HVPE is continued until a desired layer thickness has been reached. Thick layers with a thickness range of, for example, 200 µm or above, preferably in the range from 300 to 1000 µm, can in this way be obtained efficiently.

The compositions of the III-N compounds of the first layer 15 and second layer 17 may in each case be identical or different, e.g., may in each case be (Ga,Al,In)N, (Ga,Al)N, (Ga,In)N or GaN. It is also possible to vary the ratio of the different III elements within the same layer, by variably setting the respectively supplied mixing ratio from the III sources 2, 4, etc. and 23/28 etc. used. It is in this way possible, for example, for different III-N compositions to be present at the interfaces between the layers 7/15 and/or 15/17, with a desired graduated profile established between them. The graduated profile may be linearly homogenous, may vary in steps or may adopt some other curve profile.

After the HVPE growth of the III-N layer 17 in the reactor 21, the product obtained in this way is allowed to cool. During the cooling operation, the production substrate 7 flakes off the layer 15 produced by means of MBE of its own accord, and the desired free-standing III-N layer 18 comprising the thin MBE layer 15 and the thick HVPE layer 17 is obtained, as shown in Figs. 1d and 1e.

After cooling, residues 7' of the Li(Al,Ga) oxide production substrate 7 may still be adhering to the MBE layer 15 (cf. Fig. 1d'). These residues 7' can be removed by suitable methods, preferably using an etching fluid and optimally by wet-chemical means using an etching fluid, such as *aqua regia,* or by mechanical abrasion, after which the desired free-standing III-N substrate 18 is obtained (cf. Figs. 1d'-1e).

The exemplary embodiments described can be modified and/or supplemented by further process steps. Examples of particularly suitable modifications and/or additions are given below:
in step b), at least two first III-N layers are deposited at different substrate temperatures and/or different ratios of III elements, such as Ga/Al and/or different ratios of group III to group V elements;
in step b), a plasma assisted molecular beam epitaxy (PAMBE) is used instead of an ion beam assisted molecular beam epitaxy (IBA-MBE);
between steps b) and c), the surface of the MBE layer is smoothed by one or more of the following processes: wet-chemical etching, dry-chemical etching, mechanical polishing, chemical mechanical polishing (CMP), conditioning in a gas atmosphere which contains at least ammonia;
between steps a) and b) and/or b) and c), further intermediate layers comprising III-N compounds or other materials are positioned, usually meaning that they are applied, deposited or grown. These layers can consist of a variety of compounds including III-N compounds, and may partially or wholly cover the surface of one face of the III-N layer underneath;
after step e), further removing the thin MBE layer by suitable treatment such as etching, grinding, CMP or other polishing treatment or the like, in order to provide the thick III-N layer having advantageous properties.

The free-standing III-N substrate provided according to the present invention can be further processed. In particular, after causing the foreign substrate to separate from the epitaxial III-N layers by self-separation and/or by an active removal process, it is possible, if desired, to further remove the thin, less than 2 µm thick heteroepitaxial III-N layer by an appropriate active removal process, such as etching, grinding, CMP or other polishing treatment or the like, thereby providing the at least 200 µm thick homoepitaxial III-N layer as a free-standing III-N substrate having the substantial freeness of impurities and the advantageous properties as described above.

The free-standing III-N substrate in accordance with the present invention can be used in accordance with its intended application. If necessary or desired, it can be processed further. The main industrial applicability is in the semiconductor industry, in particular for opto-electronics. It is in particular possible to produce components (devices) for (Al,In,Ga)N-based light-emitting or LASER diodes by means of epitaxy on the free-standing III-N substrate produced in accordance with the invention. The substrates will also be useful in high-speed, high-temperature and high-voltage applications. In optoelectronics it may further be desirable to have an n-doped layer, such as an Si-doped layer, produced using Silane and in electronics applications it may be desirable to add a semi-isolating layer, for example using Fe-doping. The production of III-N components (devices) has heretofore only been possible at a relatively low quality and wafer size, which has implications for the average lifetime of the components, as well as performance parameters such as peak current density or brightness in optical components.

The foregoing description of preferred embodiments of the invention has been presented for purposes of illustration and description only. It is not intended to be exhaustive or to limit the invention to the precise form disclosed, and modifications and variations are possible and/or would be apparent in light of the above teachings or may be acquired from practice of the invention. The embodiments were chosen and described in order to explain the principles of the invention and its practical application to enable one skilled in the art to utilize the invention in various embodiments and with various modifications as are suited to the particular use contemplated. It is intended that the scope of the invention be defined by the claims appended hereto and that the claims encompass all embodiments of the invention, including the disclosed embodiments and their equivalents.

## Claims

1. A process for producing a III-N layer, where III denotes at least one element from group III of the periodic system, selected from Al, Ga and In, comprising the steps of:
a) depositing on an Li(Al,Ga)Ox substrate, where 1 ≤ x ≤ 3, a first III-N layer at a first temperature; and
b) depositing on the first III-N layer a second III-N layer at a second temperature, wherein the first and second temperatures are chosen such that the first temperature is at least two hundred degrees Kelvin less than the second temperature,
wherein metalorganic vapor phase epitaxy is not used in the process for producing the III-N layer, such that the III-N layer is substantially free of metalorganic vapor phase epitaxy -associated uncontrolled impurities.

2. A process for producing a free-standing III-N layer, where III denotes at least one element from group III of the periodic system, selected from Al, Ga and In, comprising
a) depositing on an Li(Al,Ga)Ox substrate, where 1 ≤ x ≤ 3; at least one first III-N layer by means of molecular beam epitaxy (MBE); and
b) depositing on the at least one first III-N layer at least one second III-N layer by means of hydride vapor phase epitaxy (HVPE),
wherein the substrate temperature during the deposition of the first III-N layer is less than about 800°C.

3. A process according to claim 1 or 2, comprising depositing at least two first III-N layers at least two different substrate temperatures and/or with at least two III-N layers of differing composition.

4. A process according to claim 3, wherein the compositions are different in their ratios of III elements and/or in their ratios of group III elements to Nitrogen.

5. A process according to any one of the preceding claims, wherein depositing the at least one first III-N layer on the Li(Al,Ga)Ox substrate comprises using an ion beam assisted molecular beam epitaxy (IBA-MBE).

6. A process according to any one of the preceding claims, wherein depositing the at least one first III-N layer on the Li(Al,Ga)Ox substrate comprises using plasma assisted molecular beam epitaxy (PAMBE).

7. A process according to any one of the preceding claims, further comprising causing said Li(Al,Ga)Ox substrate to self-separate, and/or removing Li(Al,Ga)Ox residue after b), to produce a free standing III-N substrate.

8. A process according to claim 7, wherein removing the residues of the Li(Al,Ga)Ox substrate comprises applying aqua regia.

9. A process according to claim 7 or 8, further comprising removing said first III-N layer to produce a free standing III-N substrate formed by said second III-N layer.

10. A process according to any one of the preceding claims, wherein the first and/or second III-N layer comprises a GaN layer.

11. A process according to any one of the preceding claims, further comprising smoothing the surface of the first III-N layer by one or more of the processes selected from the group consisting of wet-chemical etching, dry-chemical etching, mechanical polishing, chemical mechanical polishing (CMP), and conditioning in a gas atmosphere which contains at least ammonia.

12. A process according to any one of the preceding claims, wherein the Li(Al,Ga)Ox substrate comprises a γ-LiAlOx substrate.

13. A process according to any one of the preceding claims, further comprising positioning an intermediate layer on top of a III-N layer.

14. A free-standing III-N substrate, comprising a first III-N layer having a thickness of less than 2 microns and a second III-N layer having a thickness of at least 200 microns, wherein said second III-N layer is substantially free of impurities to an amount less than 10¹⁹ cm⁻³ derivable from a foreign substrate or from an uncontrolled epitaxy incorporation.

15. The substrate according to claim 14, wherein said first III-N layer is also substantially free of impurities derivable from a foreign substrate or from an uncontrolled epitaxy incorporation.

16. The substrate according to claim 14 or 15, wherein said second III-N layer, optionally in addition said first III-N layer, is substantially free of any one of impurities selected from the group consisting of Li, O, H and C.

17. The substrate according to claim 14, 15 or 16, wherein said first III-N layer is a MBE heteroepitaxially grown III-layer, and wherein said second III-N layer is a HVPE homoepitaxially grown III-N layer.

18. The substrate according to any one of claims 14 to 17 produced by a process according to any one of claims 1 to 13.

19. The substrate according to any one of claims 14 to 18, having a diameter of at least five centimeters.

20. The substrate according to any one of claims 14 to 19, wherein said heteroepitaxial III-N layer is removed.

21. The substrate according to any one of claims 14 to 20, wherein the homoepitaxial III-N layer comprises a GaN layer.

## Patentansprüche

1. Verfahren zum Herstellen einer III-N Schicht, wobei III mindestens ein Element der III. Gruppe des Periodensystems, ausgewählt aus Al, Ga und In, bedeutet, mit den Schritten:
a) Abscheiden einer ersten III-N Schicht auf ein Li(Al,Ga)Oₓ-Substrat bei einer ersten Temperatur, wobei 1 ≤ x ≤ 3, und
b) Abscheiden einer zweiten III-N Schicht auf die erste III-N Schicht bei einer zweiten Temperatur, wobei die erste und die zweite Temperatur so ausgewählt sind, dass die erste Temperatur mindestens 200° Kelvin weniger als die zweite Temperatur beträgt,
wobei in dem Verfahren zum Herstellen der III-N Schicht metallorganische Gasphasenepitaxie nicht verwendet wird, so dass die III-N Schicht im Wesentlichen frei von unkontrollierten, im Zusammenhang mit metallorganischer Gasphasenepitaxie stehenden Verunreinigungen ist.

2. Verfahren zum Herstellen einer freistehenden III-N Schicht, wobei III mindestens ein Element der III. Gruppe des Periodensystems, ausgewählt aus Al, Ga und In, bedeutet, das umfasst
a) Abscheiden mindestens einer ersten III-N Schicht auf einem Li(Al,Ga)Oₓ-Substrat, wobei 1 ≤ x ≤ 3, mittels Molekularstrahlepitaxie (MBE); und
b) Abscheiden mindestens einer zweiten III-N-Schicht auf der mindestens einen ersten III-N-Schicht mittels Hydridgasphasenepitaxie (HVPE),
wobei die Substrattemperatur während des Abscheidens der ersten III-N-Schicht weniger als etwa 800°C beträgt.

3. Verfahren gemäß Anspruch 1 oder 2, das das Abscheiden von mindestens zwei ersten III-N-Schichten bei mindestens zwei verschiedenen Substrattemperaturen und/oder mit mindestens zwei III-N-Schichten verschiedener Zusammensetzung umfasst.

4. Verfahren gemäß Anspruch 3, wobei sich die Zusammensetzungen in ihren Verhältnissen der III-Elemente und/oder in ihren Verhältnissen der Gruppe-III-Elemente zu Stickstoff unterscheiden.

5. Verfahren gemäß irgendeinem der vorangegangenen Ansprüche, wobei das Abscheiden der mindestens einen ersten III-N-Schicht auf dem Li(Al,Ga)Ox-Substrat das Verwenden einer Ionenstrahlunterstützten Molekularstrahlepitaxie (IBA-MBE) umfasst.

6. Verfahren gemäß irgendeinem der vorangegangenen Ansprüche, wobei das Abscheiden der mindestens ersten III-N-Schicht auf der Li(Al,Ga)Oₓ-Substrat das Verwenden einer Plasma-unterstützten Molekularstrahlepitaxie (PAMBE) umfasst.

7. Verfahren gemäß irgendeinem vorangegangenen Ansprüche, das ferner das Herbeiführen von Selbstablösung des Li(Al,Ga)Oₓ-Substrats und/oder das Entfernen von Li(Al,Ga)Oₓ-Rückstand nach b) umfasst, um ein freistehendes III-N-Substrat herzustellen.

8. Prozeß gemäß Anspruch 7, wobei das Entfernen der Rückstände des Li(Al,Ga)Oₓ-Substrats die Anwendung von Königswasser umfasst.

9. Verfahren gemäß Anspruch 7 oder 8, das ferner das Entfernen der ersten III-N-Schicht umfasst, um ein freistehendes III-N-Substrat herzustellen, das durch die zweite III-N-Schicht gebildet ist.

10. Verfahren gemäß irgendeinem der vorangegangenen Ansprüche, wobei die erste und/oder zweite III-N-Schicht eine GaN-Schicht umfasst.

11. Verfahren gemäß irgendeinem der vorangegangenen Ansprüche, das ferner das Glätten der Oberfläche der ersten III-N-Schicht durch ein oder mehrere Verfahren umfasst, das/die ausgewählt ist/sind aus der Gruppe bestehend aus: nasschemisches Ätzen, trockenchemisches Ätzen, mechanisches Polieren, chemischmechanisches Polieren (CMP) und Tempern in einer Gasatmosphäre, die mindestens Ammoniak enthält.

12. Verfahren gemäß irgendeinem der vorangegangenen Ansprüche, wobei das Li(Al,Ga)Oₓ-Substrat ein γ-LiAlOₓ-Substrat umfasst.

13. Verfahren gemäß irgendeinem der vorangegangenen Ansprüche, das ferner das Positionieren einer Zwischenschicht auf der III-N-Schicht umfasst.

14. Freistehendes III-N-Substrat, das eine erste III-N-Schicht mit einer Dicke von weniger als 2 µm und eine zweite III-N-Schicht mit einer Dicke von mindestens 200 µm umfasst, wobei die zweite III-N-Schicht im Wesentlichen frei ist von Verunreinigungen bis zu einer Menge von weniger als 10¹⁹ cm⁻³, die von einem Fremdsubstrat oder von einem unkontrollierten Epitaxieeinbau stammen.

15. Substrat gemäß Anspruch 14, wobei auch die erste III-N-Schicht im Wesentlichen frei ist von Verunreinigungen, die von einem Fremdsubstrat oder von einem unkontrollierten Epitaxieeinbau stammen.

16. Substrat gemäß Anspruch 14 oder 15, wobei die zweite III-N-Schicht, wahlweise zusätzlich die erste III-N-Schicht, im Wesentlichen frei ist von aus der aus Li, O, H und C bestehenden Gruppe ausgewählten Verunreinigungen.

17. Substrat gemäß Anspruch 14, 15 oder 16, wobei die erste III-N-Schicht eine mit MBE heteroepitaktisch gewachsene III-Schicht ist, und wobei die zweite III-N-Schicht eine mit HVPE homoepitaktisch gewachsene III-N-Schicht ist.

18. Substrat gemäß irgendeinem der Ansprüche 14 bis 17, hergestellt durch ein Verfahren gemäß irgendeinem der Ansprüche 1 bis 13.

19. Substrat gemäß irgendeinem der Ansprüche 14 bis 18 mit einem Durchmesser von mindestens 5 cm.

20. Substrat gemäß irgendeinem der Ansprüche 14 bis 19, wobei die heteroepitaktische III-N-Schicht entfernt ist.

21. Substrat gemäß irgendeinem der Ansprüche 14 bis 20, wobei die homoepitaktische III-N-Schicht eine GaN-Schicht umfasst.

## Revendications

1. Procédé de production d'une couche de III-N, où III représente au moins un élément du groupe III du système périodique, choisi parmi Al, Ga et In, comprenant les étapes consistant à :
a) déposer sur un substrat de Li(Al,Ga)Ox, où 1 ≤ x ≤ 3, une première couche de III-N à une première température ; et
b) déposer sur la première couche de III-N, une deuxième couche de III-N à une deuxième température,
dans lequel les première et deuxième températures sont choisies de sorte que la première température soit au moins deux cents degrés Kelvin au-dessous de la deuxième température,
dans lequel l'épitaxie métalorganique en phase vapeur n'est pas utilisée dans le procédé de production de la couche de III-N, de sorte que la couche de III-N est essentiellement exempte d'impuretés non contrôlées associées à l'épitaxie métalorganique en phase vapeur.

2. Procédé de production d'une couche de III-N indépendante, où III représente au moins un élément du groupe III du système périodique, choisi parmi Al, Ga et In, comprenant les étapes consistant à :
a) déposer sur un substrat de Li(Al,Ga)Ox, où 1 ≤ x ≤ 3, au moins une première couche de III-N par l'intermédiaire d'une épitaxie par faisceau moléculaire (MBE) ; et
b) déposer sur la au moins une première couche de III-N, au moins une deuxième couche de III-N par l'intermédiaire d'une épitaxie en phase vapeur aux hydrures (HVPE),
dans lequel la température du substrat pendant le dépôt de la première couche de III-N est inférieure à environ 800 °C.

3. Procédé selon la revendication 1 ou 2, comprenant le dépôt d'au moins deux premières couches de III-N à au moins deux températures de substrat différentes et/ou avec au moins deux couches de III-N de compositions différentes.

4. Procédé selon la revendication 3, dans lequel les compositions sont différentes en termes de rapports des éléments III et/ou en termes de leurs rapports des éléments du groupe III à l'azote.

5. Procédé selon l'une quelconque des revendications précédentes, dans lequel le dépôt de la au moins une première couche de III-N sur le substrat de Li(Al,Ga)Ox comprend l'utilisation d'une épitaxie par faisceau moléculaire assistée par un faisceau ionique (IBA-MBE).

6. Procédé selon l'une quelconque des revendications précédentes, dans lequel le dépôt de la au moins une première couche de III-N sur le substrat de Li(Al,Ga)Ox comprend l'utilisation d'une épitaxie par faisceau moléculaire assistée par plasma (PAMBE).

7. Procédé selon l'une quelconque des revendications précédentes, comprenant en outre la provocation de l'auto-séparation dudit substrat de Li(Al,Ga)Ox et/ou l'élimination du résidu de Li(Al,Ga)Ox après b), pour produire un substrat de III-N indépendant.

8. Procédé selon la revendication 7, dans lequel l'élimination des résidus du substrat de Li(Al,Ga)Ox comprend l'application d'eau régale.

9. Procédé selon la revendication 7 ou 8, comprenant en outre l'élimination de ladite première couche de III-N pour produire un substrat de III-N indépendant formé par ladite deuxième couche de III-N.

10. Procédé selon l'une quelconque des revendications précédentes, dans lequel la première et/ou la deuxième couche de III-N comprend une couche de GaN.

11. Procédé selon l'une quelconque des revendications précédentes, comprenant en outre le lissage de la surface de la première couche de III-N par un ou plusieurs procédés choisis dans le groupe constitué par : la gravure chimique humide, la gravure chimique sèche, le polissage mécanique, le polissage mécanique chimique (CMP) et le conditionnement sous une atmosphère gazeuse qui contient au moins de l'ammoniac.

12. Procédé selon l'une quelconque des revendications précédentes, dans lequel le substrat de Li(Al,Ga)Ox comprend un substrat de γ-LiAlOx.

13. Procédé selon l'une quelconque des revendications précédentes, comprenant en outre le positionnement d'une couche intermédiaire sur le dessus d'une couche de III-N.

14. Substrat de III-N indépendant, comprenant une première couche de III-N ayant une épaisseur inférieure à 2 microns et une deuxième couche de III-N ayant une épaisseur d'au moins 200 microns, dans lequel ladite deuxième couche de III-N est essentiellement exempte d'impuretés en une quantité inférieure à 10¹⁹ cm⁻³ provenant d'un substrat étranger ou de l'incorporation d'une épitaxie non contrôlée.

15. Substrat selon la revendication 14, dans lequel ladite première couche de III-N est également essentiellement exempte d'impuretés provenant d'un substrat étranger ou de l'incorporation d'une épitaxie non contrôlée.

16. Substrat selon la revendication 14 ou 15, dans lequel ladite deuxième couche de III-N, facultativement en plus de ladite première couche de III-N, est essentiellement exempte de l'une quelconque des impuretés choisies dans le groupe constitué par Li, O, H et C.

17. Substrat selon la revendication 14, 15 ou 16, dans lequel ladite première couche de III-N est une couche de III-N cultivée de manière hétéroépitaxiale par MBE et dans lequel ladite deuxième couche de III-N est une couche de III-N cultivée de manière hétéroépitaxiale par HVPE.

18. Substrat selon l'une quelconque des revendications 14 à 17, produit par un procédé selon l'une quelconque des revendications 1 à 13.

19. Substrat selon l'une quelconque des revendications 14 à 18, ayant un diamètre d'au moins cinq centimètres.

20. Substrat selon l'une quelconque des revendications 14 à 19, dans lequel ladite couche de III-N hétéroépitaxiale est éliminée.

21. Substrat selon l'une quelconque des revendications 14 à 20, **caractérisé en ce que** ladite couche de III-N hétéroépitaxiale comprend une couche de GaN.
